# EUROPÄISCHE PATENTSCHRIFT

(11) **EP 0 607 207 B1**
(45) Veröffentlichungstag und Bekanntmachung des Hinweises auf die Patenterteilung: **19.07.1995**
(21) Anmeldenummer: 92920585.4
(22) Anmeldetag: 29.09.1992
(51) Int. Cl.: G01R 31/02

(54) **VERFAHREN UND VORRICHTUNG ZUM ÜBERPRÜFEN DER VERKABELUNG ZWISCHEN EINEM SCHALTSCHRANK UND AN DIESEN ANGESCHLOSSENEN FELDGERÄTEN**
PROCESS AND DEVICE FOR CHECKING THE WIRING BETWEEN AN ELECTRICAL CUBICLE AND FIELD DEVICES CONNECTED THERETO
PROCEDE ET DISPOSITIF POUR LE CONTROLE DU CABLAGE ENTRE UNE ARMOIRE ELECTRIQUE ET LES APPAREILS A CHAMP QUI LUI SONT RACCORDES

(30) Priorität: 08.10.1991 DE 4133354
(43) Veröffentlichungstag der Anmeldung: 27.07.1994
(73) Patentinhaber: TECHNOSERV GMBH, W-6200 Wiesbaden (DE)
(72) Erfinder: REDMER, Bernd, D-6204 Taunusstein-Neuhof (DE)
(74) Vertreter: Grünecker, Kinkeldey, Stockmair & Schwanhäusser Anwaltssozietät
(86) Internationale Anmeldenummer: EP9202246
(87) Internationale Veröffentlichungsnummer: WO9307501

(56) Entgegenhaltungen:
- US-A- 3 182 253
- US-A- 3 891 811
- US-A- 4 916 444
- US-A- 4 937 529
- ELEKTOR ELECTRONICS. Bd. 16, Nr. 177, April 1990, CANTERBURY GB Seiten 27 - 31'WIRING ALLOCATION TESTER' in der Anmeldung erw hnt
- NTIS TECH NOTES. Juni 1988, SPRINGFIELD, VA US Seite 466 OAK RIDGE NATIONALLABORATORY 'REMOTE SENSOR AND CABLE IDENTIFIER'

## Beschreibung

Die Erfindung bezieht sich auf ein Verfahren zum Überprüfen der Verkabelung zwischen einem Schaltschrank und an diesen angeschlossenen, mit großem Abstand aufgestellten Feldgeräten, bei dem man auf sämtliche mit einer zu prüfenden Kabelader versehene Aus- oder Eingänge des Schaltschranks eine dem jeweiligen Ein- oder Ausgang zugeordnete digitale Adresse aufspielt, und man die Adressen in einer Soll-Liste den jeweiligen Feldgeräten zuordnet, und an den Feldgeräten die Adressen der Ein- und Ausgänge des Schaltschranks über die damit verbundenen Kabeladern abfragt und mit der Soll-Liste vergleicht, wobei man am feldgerätseitigen Ende der zu prüfenden Kabelader mittels eines Handtestgerätes einen Erdstom initiiert, welcher das Aufspielen der digitalen Adresse des dem zu prüfenden Kabel zugeordneten Ein- oder Ausgangs auf mindestens die zu prüfende Kabelader bewirkt.

Bei der Erstellung von regeltechnischen Anlagen in Gebäuden muß nach Anschluß aller verlegten Kabel, die ein Feldgerät, wie z.B. einen Temperaturfühler oder einen Stellmotor, mit einem Schaltschrank verbinden, jedes einzelne dieser Kabel auf die Richtigkeit dieses Anschlusses überprüft werden. Hierzu geht man bislang so vor, daß eine erste Person an dem Schaltschrank steht und eine zweite Person an dem jeweiligen Feldgerät. Die Prüfung des Kabels erfolgt mittels einer sog. "Durchklingelprüfung", Die beiden Personen können sich über ein Funkgerät verständigen, so daß auch Funktionsprüfungen der Feldgeräte vorgenommen werden können. Grundsätzlich kann aber nur geprüft werden, ob die Verkabelung richtig erfolgt ist oder nicht. Falls beobachtet wird, daß ein bestimmtes Kabel nicht zu dem zugehörigen Feldgerät führt, läßt sich mit der bekannten Methode nicht feststellen, wo der Fehler liegt bzw. wohin das Kabel tatsächlich führt. Bei Bauprojekten mittlerer Größenordnung werden zwischen 3000 und 10 000 Kabel auf diese Weise geprüft. Da für die Prüfung zwei Personen benötigt werden, ist leicht vorstellbar, daß allein für das Überprüfen der Verkabelung ein beträchtlicher Aufwand an Personalkosten entsteht. Dieser Aufwand erhöht sich enorm, falls Fehler in Form von Vertauschungen auftreten. Da mit der bekannten Methode nicht festgestellt werden kann, wohin die vertauschten Kabel führen, ist es in der Regel erforderlich, die komplette Verkabelung neu zu verlegen. Da der Bau in dieser Phase bereits fortgeschritten ist, entstehen nochmals Kosten, die weit höher liegen als bei der ursprünglichen Verkabelung.

Es sind Verfahren der eingangs genannten Art bekannt, mit denen sich die Kabel einem Aus- oder Eingang eines Schaltschranks zuordnen lassen.

Ein solches Verfahren ist beispielsweise in der US-A-3891811 beschrieben. Dort ist eine Person mit einem Handtestgerät ausgestattet mit dem am feldgerätseitigen Ende der Kabelader ein Erdstrom initiiert wird, der bewirkt, daß auf das betreffende Kabel eine dem Kabel zugeordnete digitale Adresse aufgespielt wird, die mit dem Handtestgerät lesbar ist. Jedoch sind die Einsatzmöglichkeiten bei diesem Verfahren eingeschränkt. So läßt sich zum Beispiel beim Einsatz mehrerer Handtestgeräte nicht feststellen mit welchem Handtestgerät eine Überprüfung der Verkabelung gerade durchgeführt wird.

Aufgabe ist es daher, die Einsatzmöglichkeiten eines Verfahrens der eingangs genannten Art zu erweitern.

Die Aufgabe wird erfindungsgemäß dadurch gelöst, daß man am feldgerätseitigen Ende der Kabelader ein dem jeweiligen Handfeldgerät zugeordnetes Kennungssignal aufspielt, wobei der initiierte Erdstrom das Aufspielen einer Kombination aus Kennungssignal und Adresse des der zu prüfenden Kabelader zugeordneten Ein- oder Ausgangs des Schaltschranks auf die Adern aller Kabel bewirkt.

Der Vorteil dieses erfindungsgemäßen Verfahrens liegt darin, daß das zu überprüfende Kabel als Komunukationskabel verwendet wird. Durch das dem jeweiligen Handfeldgerät zugeordnete Kennungssignal kann zum Beispiel festgestellt werden, welches Handtestgerät zum Überprüfen der Verkabelung eingesetzt wird. Es ist auch denkbar andere Kennungen auf die Kabelader aufzuspielen, wodurch es möglich ist, Informationen zwischen dem Schaltschrank und einer das Handtestgerät bedienenden Person auszutauschen.

So läßt sich zum Beispiel die Funktion einzelner als Arbeitsfeldgeräte ausgebildeter Feldgeräte überprüfen, indem man an den zu den zu prüfenden Arbeitsfeldgeräten führenden Ausgänge des Schaltschrankes eine Arbeitsspannung anlegt, die das Arbeitsfeldgerät in einen vorbestimmten Arbeitszustand verstellt.

Auch ermöglicht dieses Verfahren, daß man zur Funktionsprüfung von als Meßfeldgeräten ausgebildeten Feldgeräten die am Schaltschrank zu einer bestimmten Zeit gemessenen Daten festhält und gleichzeitig am Ort des jeweiligen Meßfeldgerätes die jeweilige physikalische Größe mit einem anderen Meßgerät mißt und festhält. So kann zum Beispiel zu einem bestimmten Zeitpunkt am Meßfeldgerät die das Meßfeldgerät umgebende Temperatur gemessen werden und anschließend nach Beendigung der Kabelprüfung mit den vom Meßfeldgerät aufgenommenen Werten verglichen werden.

Die Vorrichtung zum Überprüfen der Verkabelung zwischen einem Schaltschrank und an diesen angeschlossenen, mit großem Abstand aufgestellten Feldgeräten, die über jeweils zu prüfende Kabeladern mit Aus- oder Eingängen des Schaltschrankes verbunden sind, auf die eine dem jeweiligen Ein- oder Ausgang zugeordnete digitale Adresse aufspielbar ist und wobei ferner das Aufspielen der Adressen durch einen Erdstom initiiert wird, ist gekennzeichnet durch einen Testrechner mit einer Vielzahl von digital adressierbaren Ausgängen, die mit den Ein- und Ausgängen des Schaltschrankes verbindbar sind, und durch ein mikroprozessorgesteuertes Handtestgerät mit einem Adressenleser und einer Erdungstaste, wobei das Handtestgerät einen ersten Signalgeber für ein auf das zu prüfende Kabel aufzuspielendes, dem Handtestgerät zugeordnetes Kennungssignal umfaßt, und wobei die durch den Erdstrom des Handtestgeräts initiierte und durch den Testrechner aufgespielte, dem mit dem zu prüfenden Kabel verbundenen Ein- oder Ausgang des Schaltschranks zugeordnete Adresse um das Kennungssignal ergänzt wird, und wobei ferner das Handtestgerät nur Adressen liest, die um das Kennungssignal ergänzt sind, und wobei der Testrechner einen Speicher umfaßt, in welchem das Kennungssignal zugeordnet zu der Adresse mit der jeweiligen Kabelader verbundenen Ausgangs des Schaltschranks gespeichert wird.

In einer vorteilhaften Weiterbildung sind mehrere Handtestgeräte mit verschiedenen Kennungssignalen vorgesehen. Ferner spielt der Testrechner nach Initiierung durch den Erdstrom die durch das jeweilige Kennungssignal ergänzte Adresse auf alle Kabeladern auf.

Der Einsatzbereich des Handtestgerätes läßt sich erweitern, indem die Handtestgeräte einen zweiten Signalgeber umfassen, der bei Betätigung einer Taste über die zu prüfende Kabelader ein Steuersignal an den Testrechner sendet, woraufhin der Testrechner den zugehörigen Ausgang des Schaltschranks auf Arbeitsspannung setzt. Dies ist insbesondere von Vorteil zur Funktionsüberprüfung von Feldgeräten.

Insbesondere zum Messen physikalischer Größen hat es sich als günstig erwiesen, daß die Schaltschranksteuerung einen Kommunikationsanschluß aufweist, an dem der Testrechner anschließbar ist, und daß der Testrechner so ausgelegt ist, daß das von dem Handtestgerät ausgesendete Kennungssignal beim Empfang durch den Testrechner das Auslesen und Speichern eines Meßprotokolls der Schaltschranksteuerung des Schaltschrankes steuert.

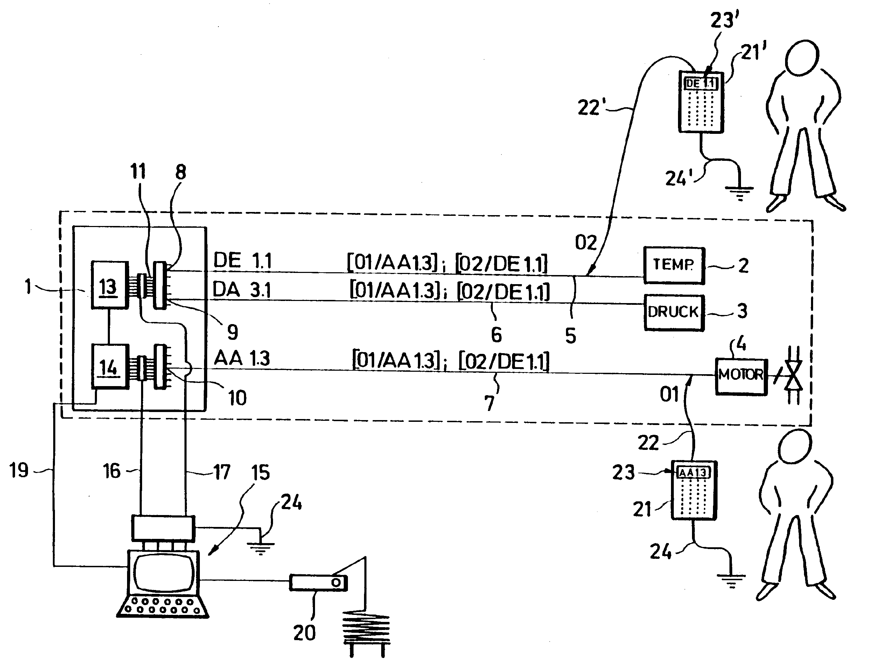

Im folgenden wird die Erfindung beispielhaft anhand einer Zeichnung näher erläutert. Die einzige Figur zeigt in einer schematischen Darstellung eine erfindungsgemäße Testvorrichtung beim Überprüfen der Verkabelung zwischen einem Schaltschrank 1 und zugehörigen Feldgeräten 2 bis 4.

Der Übersichtlichkeit halber sind nur drei Feldgeräte (Kabelanschlüsse) gezeigt. Die Erfindung ist jedoch, wie sich aus der späteren Erläuterung noch ergibt, prinzipiell für beliebig viele Feldgeräte anwendbar.
Die Feldgeräte 2 bis 4 sind über einzelne Kabel 5 bis 7 mit Ein- bzw. Ausgängen 8 bis 10 des Schaltschranks 1 verbunden.

Die erfindungsgemäße Testvorrichtung umfaßt einen Testrechner 15 mit einem Controller, dessen Ein- und Ausgänge über Adapter an die Kabel 8 bis 10 im Schaltschrank 1 angeschlossen sind. Ferner ist der Testrechner 15 über eine Kommunikationsleitung 19 noch an die Steuerungen 13 und 14 des Schaltschrankes 1 angeschlossen. Der Testrechner 15 ist außerdem an einen Protokolldrucker 20 angeschlossen.

Schließlich umfaßt die Testvorrichtung noch mikroprozessorgesteuerte Handtestgeräte 21 und 21′, welche mittels einer mit einer Klemme versehenen Prüfleitung 22, 22′ an die Kabel 5 bis 7 angeschlossen werden können. Das Handtestgerät umfaßt ein Display 23, 23′ und ebenso wie der Controller des Testrechners 15 einen Erdausgang 24, 24′.

Wie in der Zeichnung nicht näher dargestellt ist, umfaßt der Testrechner 15 neben einem handelsüblichen Personal Computer als Leitrechner ein Controllermodul, das aus einem 8051 Microcontroller, einem 32 kByte EPROM, 5 kBYte RAM, zwei seriellen Schnittstellen, einem FSK-Modem und der Bus-Kontroll-Logik besteht. An das Controllermodul angeschlossen sind verschiedene Ein- und Ausgangsmodule, die die erforderliche Hardware zur Durchführung der Tests aufweisen, als da sind: Gleichstromquellen, Modem-Kabeladapter, Strom-Meßkreis, Adressdecoder und Bus-Adpater. Die Gleichstromquelle liefert 20 mA. Mit einem solchen Ein- und Ausgangsmodul können 16 Kabel getestet werden; bei einer ersten Ausführung des Geräts können 16 solcher Ein- und Ausgangsmodule angeschlossen werden, so daß sich insgesamt 256 Kabel auf einmal testen lassen. Die Anzahl der zu testenden Kabel ist hierauf jedoch nicht beschränkt.

Das Handtestgerät 21, 21′ umfaßt neben dem Display 23, 23′ zur alphanumerischen Anzeige eine Tastatur und eine serielle Schnittstelle, über welche die Prüfleitung 22, 22′ an die Kabel 5 bis 7 anschließbar ist. Ferner umfaßt jedes Handtestgerät einen Signalgeber zum Aufspielen eines Kennungssignals (01 bzw. 02) auf das zu prüfende Kabel 5 und 7.

Im folgenden wird nun das erfindungsgemäße Verfahren anhand der oben beschriebenen Zeichnung näher erläutert.

Zunächst wird der Testrechner 15 mit seinen beiden Flachbandkabeln 16 und 17 an den Adapter für die Anschlüsse 8 bis 10 angeschlossen. Dies kann mit Hilfe von handelsüblichen Klemmleisten geschehen. Auf diese Weise sind die einzelnen Ausgänge der Ein- und Ausgangsmodule des Testrechners 15 mit den einzelnen Ausgängen 8 bis 10 der Schaltschranksteuerungen verbunden. Dann wird der Testrechner 15 noch über die Kommunikationsleitung 19 mit den Steuerungen 13 und 14 des Schaltschrankes verbunden.

Den einzelnen Ausgängen des Controllers des Testrechners sind digitale Adressen zugeordnet, z.B. DE 1.1, DA 3.1 und AA 1.3. Die Ausgänge des Testrechners sind über die Ausgänge 8 bis 10 des Schaltschrankes mit den zu prüfenden Kabeladern 5, 6, 7 verbunden.

Nachdem der Testrechner angeschlossen und die Adressenzuordnung abgelegt wurde, bedarf es dort keiner Bedienperson mehr. Die Prüfperson bewegt sich nun vielmehr zusammen mit dem Handtestgerät 21 zu den Feldgeräten 2 bis 4, die über die Kabeladern 5 bis 7 an den Schaltschrank 1 angeschlossen sind. Eine zweite Person kann sich des Handtestgerätes 21′ bedienen.

Das Handtestgerät 21, 21′ wird zunächst geerdet und dann mit der Prüfleitung 22, 22′ an eine aus einer Checkliste (Soll-Liste) ersichtliche Kabelader 7 bzw. 5 angeschlossen. Die Soll-Liste entspricht der im Testrechner 15 abgelegten Adressenzuordnung. Das Handtestgerät 21, 21′ sendet nun sein Kennungssignal (z.B. 01 für Gerät 21 und 02 für Gerät 21′) an den Testrechner 15. Der Testrechner spielt als Antwort auf dieses Signal die dem entsprechenden Ausgang 10 bzw. 8 des Schaltschranks 1 zugeordnete Adresse, ergänzt um das Kennungssignal 01 bzw. 02, auf alle Kabeladern 5 bis 7 auf. Das bedeutet, daß alle Kabeladern 5 bis 7 mit den ergänzten Adressen 01/AA 1.3 und 02/DE 1.1 belegt sind.

Der Adressenleser der Handtestgeräte 21 und 21′ kann aber nur die um die Kennung (01 bzw. 02) des eigenen Handtestgerätes 21 bzw. 21′ ergänzte Adresse lesen. Das heißt, das Gerät 21 liest die Adresse 01/AA 1.3 und das Gerät 21′ die Adresse 02/DE 1.1. Die so gelesene Adresse wird in dem jeweiligen Display 23 bzw. 23′ des jeweiligen Handtestgerätes 21 bzw. 21′ angezeigt. Die eine Prüfperson mit dem Gerät 21 hakt nunmehr die Adresse AA 1.3 in der Soll-Liste ab oder trägt die gegebenenfalls falsche Adresse in die Liste ein. In gleicher Weise verfährt die Person mit dem zweiten Gerät 21′ mit der Adresse DE 1.1.

Durch das vom Handtestgerät 21 bzw. 21′ gesendete Kennungssignal 01 bzw. 02 wird beim Anlegen der Prüfleitung 22 bzw. 22′ an die Kabeladern 7 bzw. 5 ein Impuls an den Testrechner 15 gegeben, der dort in einem Speicher der Adresse AA 1.3 die Kennung 01 und der Adresse DE 1.1 die Kennung 02 zuordnet. Daraus kann später ersehen werden, daß der entsprechende Ausgang 10 bzw. 8 des Schaltschrankes geprüft wurde und auch, von wem er geprüft wurde.

Mit dem Testsystem ist zudem auch eine Funktionsprüfung durchführbar. Beide Handtestgeräte 21, 21′ verfügen hierzu über einen zweiten Signalgeber, mit dem ein Steuersignal an den Testrechner ausgesendet werden kann.

Bei der Überprüfung des Feldgerätes 4 wird z.B. so vorgegangen, daß mit dem Handtestgerät 21 ein Steuersignal an den Testrechner 15 gesendet wird, der den Ausgang 10 des Schaltschrankes 1 auf Arbeitsspannung setzt. Dadurch kann die Prüfperson durch einfache Sichtprüfung feststellen, ob der Stellmotor 4 das Ventil auch in die geöffnete bzw. geschlossene Stellung bringt, was der Fall sein müßte, wenn der Ausgang 10 mit der Adresse AA 1.3 auf Arbeitsspannung gesetzt ist. Die Funktionsprüfung der Sensoren, z.B. des Temperaturfühlers 2, erfolgt folgendermaßen. Wenn über das Handtestgerät 21′ über den zweiten Signalgeber ein Steuersignal an den Testrechner 15 gesendet wird, wird dort eine Routine gestartet, die über die Leitung 15 von dem Schaltschrank ein Meßprotokoll abfragt. In diesem Meßprotokoll wird u.a. die am Schaltschrank mit Hilfe des Temperaturfühlers 2 gemessene Temperatur protokolliert, zusammen mit der Uhrzeit der Messung. Die Prüfperson mißt nun am Ort des Temperaturfühlers 2 mit einem Handthermometer die Temperatur und protokolliert diesen Wert zusamen mit der Uhrzeit. In analoger Weise kann die Überprüfung der Kabelader 5 erfolgen.

Der Begriff Feldgerät ist nicht nur auf Sensoren und Motoren beschränkt; es kann sich vielmehr ebenfalls um Schalt- oder auch Rangierschränke handeln.

Der Begriff Liste ist nicht notwendigerweise so zu verstehen, daß es sich um eine papierne Liste handelt. Es ist vielmehr möglich, die zu vergleichenden Daten auf allen üblichen Datenträgern, z.B. auch im Speicher eines Rechners zu speichern. Selbstverständlich kann das Handtestgerät 21 auch mit einem Speicher versehen sein, so daß die Prüfperson die Ist-Liste nicht von Hand erstellen muß, sondern in dem Handtestgerät speichern kann.

Nach Abschluß des Kabeltestens können nun von der Prüfperson anhand der Checkliste ggfs. Verdrahtungs- und Offsetarbeiten durchgeführt werden.

Eine weitere Möglichkeit der Kosteneinsparung wäre, zuerst die Anklemmarbeiten im Schaltschrank durchzuführen, dann den Testrechner 15 anzuschließen und nun mit dem Anschließen der Feldgeräte 2 bis 4 zu beginnen, wobei vor jedem Anschließen mit dem Handtestgerät 21 auf richtige Ader- und Kabelzugehörigkeit geprüft wird. Dadurch läßt sich ein nachträglicher Test komplett einsparen.

## Patentansprüche

1. Verfahren zum Überprüfen der Verkabelung zwischen einem Schaltschrank (1) und an diesen angeschlossenen, mit großem Abstand aufgestellten Feldgeräten (2 bis 4), bei dem man auf sämtliche mit einer zu prüfenden Kabelader (5 bis 7) versehene Aus- oder Eingänge (8 bis 10) des Schaltschranks (1) eine dem jeweiligen Ein- oder Ausgang zugeordnete digitale Adresse (DE 1.1, DA 3.1, AA 1.3) aufspielt, und man die Adressen in einer Soll-Liste den jeweiligen Feldgeräten zuordnet, und an den Feldgeräten (2 bis 4) die Adressen der Ein- und Ausgänge (8 bis 10) des Schaltschranks (1) über die damit verbundenen Kabeladern ( 5 bis 7) abfragt und mit der Soll-Liste vergleicht, wobei man am feld geräteseitigen Ende der zu prüfenden Kabelader (5 bzw. 7) mittels eines Handtestgerätes (21, 21′) einen Erdstrom initiiert, welcher das Aufspielen der digitalen Adresse (DE 1.1 bzw. AA 1.3) des dem zu prüfenden Kabel (5 bzw. 7) zugeordneten Ein- oder Ausgangs (8 bzw.10) auf mindestens die zu prüfende Kabelader (5 bis 7) bewirkt, **dadurch gekennzeichnet**, daß man am feldgeräteseitigen Ende der Kabelader (5 bzw.7) ein dem jeweiligen Handtestgerät (21, 21′) zugeordnetes Kennungssignal (02 bzw.01) aufspielt, wobei der initiierte Erdstrom das Aufspielen einer Kombination aus Kennungssignal (02;01) und Adresse (AA 1.3 bzw. DE 1.1) des der zu prüfenden Kabelader (7 bzw. 5) zugeordneten Ein- oder Ausgangs (10 bzw. 8) des Schaltschranks (1) auf die Adern (5 bis 7) aller Kabel bewirkt.

2. Verfahren nach Anspruch 1, **dadurch gekennzeichnet**, daß man die Funktion einzelner als Arbeitsfeldgeräte (4) ausgebildete Feldgeräte überprüft, indem man an den zu prüfenden Arbeitsfeldgeräten (4) führenden Ausgängen (10) des Schaltschrankes (1) eine Arbeitsspannung anlegt, die das Arbeitsfeldgerät (4) in einen vorbestimmten Arbeitszustand verstellt.

3. Verfahren nach einem der Ansprüche 1 oder 2, **dadurch gekennzeichnet**, daß man zur Funktionsprüfung von als Meßfeldgeräten (2, 3) ausgebildeten Feldgeräten die am Schaltschrank (1) zu einer bestimmten Zeit gemessen Daten festhält und gleichzeitig am Ort des jeweiligen Meßfeldgerätes (2, 3) die jeweilige physikalische Größe mit einem anderen Meßgerät mißt und festhält.

4. Vorrichtung zum Überprüfen der Verkabelung zwischen einem Schaltschrank und an diesen angeschlossen, mit großem Abstand aufgestellten Feldgeräten (2 bis 4), die über jeweils zu prüfende Kabeladern (5 bis 7) mit Aus- oder Eingängen (8 bis 10) des Schaltschranks (1) verbunden sind, auf die eine dem jeweiligen Ein- oder Ausgang zugeordnete digitale Adresse (DE 1.1, DA 3.1, AA 1.3) aufspielbar ist und wobei ferner das Aufspielen der Adressen durch einen Erdstrom initiiert wird, zum Durchführen des Verfahrens nach einem der Ansprüche 1 bis 3, **gekennzeichnet durch,** einen Testrechner (15) mit einer Vielzahl von digital adressierbaren Ausgängen, die mit den Ein- und Ausgängen (8 bis 10) des Schaltschrankes (1) verbindbar sind, und ein mikroprozessorgesteuertes Handtestgerät (21, 21′) mit einem Adressenleser und einer Erdungstaste, wobei das Handtestgerät (21, 21′) einen ersten Signalgeber für ein auf das zu prüfende Kabel (5,7) aufzuspielendes, dem Handtestgerät (21,21′) zugeordnetes Kennungssignal (01,02) umfaßt, wobei die durch den Erdstrom des Handtestgerätes initiierte und durch den Testrechner (15) aufgespielte, dem mit dem zu prüfenden Kabel (5,7) verbundenen Ein- oder Ausgang (8,10) des Schaltschranks (1) zugeordnete Adresse (DE 1.1; AA 1.3) um das Kennungssignal (01,02) ergänzt wird, und wobei ferner das Handtestgerät (21,21′) nur Adressen liest, die um das Kennungssignal (01,02) ergänzt sind, und wobei der Testrechner (15) einen Speicher umfaßt, in welchem das Kennungssignal (01,02) zugeordnet zu der Adresse (AA 1.3; DE 1.1) des mit der jeweiligen Kabelader (7,5) verbundenen Ausgangs (10,8) des Schaltschranks (1) gespeichert wird.

5. Vorrichtung nach Anspruch 4, **dadurch gekennzeichnet**, daß mehrere Handtestgeräte (21,21′) mit verschiedenen Kennungssignalen (01,02) vorgesehen sind, und daß der Testrechner (15) nach Initiierung durch den Erdstrom die durch das jeweilige Kennungssignal ergänzte Adresse auf alle Kabeladern (5 bis 7) aufspielt.

6. Vorrichtung nach Anspruch 5, **dadurch** **gekennzeichnet,** daß die Handtestgeräte (21,21′) einen zweiten Signalgeber umfassen, der bei Betätigung einer Taste über die zu prüfende Kabelader (7) ein Steuersignal an den Testrechner (15) sendet, woraufhin der Testrechner (15) den zugehörigen Ausgang (10) des Schaltschranks (1) auf Arbeitsspannung setzt.

7. Vorrichtung nach einem der Ansprüche 4 bis 6, **dadurch gekennzeichnet**, daß die Schaltschranksteuerung einen Kommunikationsanschluß aufweist, an dem der Testrechner (15) anschließbar ist, und daß der Testrechner (15) so ausgelegt ist, daß das von dem Handtestgerät ausgesandte (21, 21′) Kennungssignal (01,02) beim Empfang durch den Testrechner (15) das Auslesen und Speichern eines Meßprotokolls der Schaltschranksteuerung des Schaltschrankes steuert.

## Claims

1. A method of checking wiring between a switchbox (1) and field units (2 to 4) connected thereto at a considerable distance therefrom, wherein there is impressed on all the outputs or inputs (8 to 10) of the switchbox (1) provided with a cable core (5 to 7) for testing, a digital address (DE 1.1, DA 3.1, AA 1.3) associated with the respective input or output, and the addresses are associated with the respective field units in a target list and the addresses of the inputs and outputs (8 to 10) of the switchbox (1) are interrogated at the field units (2 to 4) via the cable cores (5 to 7) connected to the switchbox (1) and are compared with the target list, an earth current being initiated by means of a hand test unit (21, 21′) at that end of the cable cores (5; 7) for testing which is adjacent the field unit, such earth current causing the digital address (DE 1.1 or AA 1.3) of the input or output (8; 10) associated with the cable (5; 7) for testing to be impressed at least on the cable core (5 - 7) for testing, characterised in that an identification signal (02; 01) associated with the respective hand test unit (21, 21′) is impressed on that end of the cable core (5; 7) which is adjacent the field unit, the initiated earth current causing a combination of identification signal (02; 01) and address (AA 1.3; DE 1.1) of the input or output (10; 8) of the switchbox (1) associated with the cable core (7; 5) for testing to be impressed on the cores (5 - 7) of all the cables.

2. A method according to claim 1, characterised in that the function of individual field units constructed as working field units (4) is checked by applying to the outputs (10) of the switchbox (1) leading to the working field units (4) for testing a working voltage which sets the working field unit (4) into a predetermined working state.

3. A method according to claim 1 or 2, characterised in that for the purpose of checking the function of field units constructed as measuring field units (2, 3) the data measured at the switchbox (1) at a specific time is retained and at the same time the relevant physical magnitude at the location of the respective measuring field unit (2, 3) is measured and retained by means of another measuring unit.

4. Apparatus for checking the wiring between a switchbox and field units (2 - 4) connected thereto at a considerable distance therefrom, the field units being connected, via cable cores (5 - 7) each for testing, to outputs or inputs (8 - 10) of the switchbox (1), on to which there can be impressed a digital address (DE 1.1, DA 3.1, AA 1.3) associated with the respective input or output, and wherein in addition impressing of the addresses is initiated by an earth current, for performing the method according to any one of claims 1 to 3, characterised by a test computer (15) having a plurality of digitally addressable outputs connectable to the inputs and outputs (8 - 10) of the switchbox (1), and a microprocessor-controlled hand test unit (21, 21′) with an address reader and an earthing key, the hand test unit (21, 21′) comprising a first signal transmitter for an identification signal (01, 02) associated with the hand test unit (21, 21′) and adapted to be impressed on the cable (5, 7) for testing, the address (DE 1.1; AA 1.3) initiated by the hand test unit earth current and impressed by the test computer (15), and associated with the input or output (8, 10) of the switchbox (1) connected to the cable (5, 7) for testing is completed by the identification signal (01, 02) and wherein also the hand test unit (21, 21′) reads only addresses which are completed by the identification signal (01, 02), and wherein the test computer (15) comprises a memory in which there is stored the identification signal (01, 02) associated with the address (AA 1.3; DE 1.1) of the output (10.8) of switchbox (1) connected to the respective cable core (7, 5).

5. Apparatus according to claim 4, characterised in that a number of hand test units (21, 21′) are provided with different identification signals (01, 02), and in that the test computer (15) after initiation by the earth current impresses on all the cable cores (5 - 7) the address completed by the respective identification signal.

6. Apparatus according to claim 5, characterised in that the hand test units (21, 21′) comprise a second signal transmitter which, on actuation of a key, transmits a control signal to the test computer (15) via the cable core (7) for testing, whereupon the test computer (15) sets the associated output (10) of the switchbox (1) to working voltage.

7. Apparatus according to any one of claims 4 to 6, characterised in that the switchbox control has a communication connection to which the test computer (15) can be connected and in that the test computer (15) is so designed that the identification signal (01, 02) transmitted by the hand test unit (21, 21′) on reception by the test computer (15) controls the readout and storage of a measuring protocol of the switchbox control system.

## Revendications

1. Procédé pour le contrôle du câblage entre une armoire électrique (1) et des appareils sur champ (2 à 4) raccordés à celle-ci et placés à grande distance, dans lequel on envoie, sur toutes les entrées et sorties (8 à 10) de l'armoire électrique (1) qui sont munies d'un conducteur de câble (5 à 7) à tester, une adresse numérique (DE 1.1, DA 3.1, AA 1.3) associée à l'entrée ou sortie correspondante, et on associe les adresses aux appareils sur champ correspondants dans une liste de consigne, et l'on interroge sur les appareils sur champ (2 à 4) les adresses des entrées et sorties (8 à 10) de l'armoire électrique (1) par l'intermédiaire des coonducteurs de câble (5 ou 7) qui y sont reliés et on les compare à la liste de consigne, en initiant sur l'extrémité côté appareil sur champ du conducteur de câble (5 ou 7) à tester, au moyen d'un appareil de test portatif (21, 21′), un courant de masse qui provoque l'envoi, au moins sur le conducteur de câble (5 ou 7) à tester, de l'adresse numérique (DE 1.1 ou AA 1.3) de l'entrée ou sortie (8 ou 10) associée au conducteur de câble (5 à 7) à tester, caractérisé en ce que l'on envoie, à l'extrémité côté appareil sur champ du conducteur de câble (5 ou 7), un signal d'identification associé à chaque appareil de test portatif (21, 21′), le courant de terre initié provoquant l'envoi, sur tous les conducteurs (5, 7) de tous les câbles, d'une combinaison de signal d'identification (02; 01) et d'adresse (DE 1.1 ou AA 1.3) de l'entrée ou sortie (8 ou 10) de l'armoire électrique (1) associée au conducteur de câble à tester (7 ou 5).

2. Procédé selon la revendication 1, caractérisé en ce qu'on contrôle le fonctionnement de différents appareils sur champ conformés en appareils de travail sur champ (4) en appliquant sur les sorties (10) de l'armoire électrique (1) conduisant aux appareils de travail sur champ (4) à contrôler une tension de travail qui place l'appareil de travail sur champ (4) dans un état d'activité prédéterminé.

3. Procédé selon l'une des revendications 1 ou 2, caractérisé en ce que, pour contrôler le fonctionnement d'appareils sur champ conformés en appareils de mesure sur champ (2, 3), on enregistre les données mesurées à un instant donné au niveau de l'armoire électrique (1) et, simultanément, on mesure et on enregistre avec un autre appareil de mesure la grandeur physique correspondante, sur le lieu de l'appareil de mesure sur champ (2, 3) concerné.

4. Dispositif de contrôle du câblage entre une armoire électrique (1) et des appareils sur champ (2 à 4) raccordés à celle-ci et placés à grande distance, qui sont reliés par des conducteurs de câble respectifs (5 à 7) à tester à des entrées ou sorties (8 à 10) de l'armoire électrique (1), câbles sur lesquels on peut envoyer une adresse numérique (DE 1.1, DA 3.1, AA 1.1) associée à chaque entrée ou sortie, l'envoi des adresses étant de plus initié par un courant de terre, pour effectuer le procédé selon l'une des revendications 1 à 3, caractérisé par un ordinateur de test (15) comprenant une multiplicité de sorties à adressage numérique qui peuvent être raccordées aux entrées et sorties (8 à 10) de l'armoire électrique (1), et par un appareil de test portatif (21, 21′) piloté par microprocesseur, comprenant un lecteur d'adresses et une touche de mise à la terre, l'appareil de test portatif (21, 21′) comprenant un premier émetteur de signal pour un signal d'identification (01, 02) associé à l'appareil de test portatif (21, 21′) et à envoyer sur le câble (5, 7) à tester, et l'adresse (DE 1.1; AA 1.3), initiée par le courant de terre et envoyée par l'ordinateur de test (15), associée à l'entrée ou sortie (8, 10) de l'armoire électrique (1) correspondant au câble (5, 7) à tester étant complétée du signal d'identification (01, 02), et l'appareil de test portatif (21, 21′) ne lisant que des adresses qui sont complétées du signal d'identification (01, 02), et l'ordinateur de test (15) comprenant une mémoire dans laquelle le signal d'identification (01, 02) est stocké en association avec l'adresse (AA 1.3; DE 1.1) de la sortie (10, 8) de l'armoire électrique (1) reliée au conducteur de câble (7, 5) correspondant.

5. Dispositif selon la revendication 4, caractérisé en ce que plusieurs appareils de test portatifs (21, 21′) avec différents signaux d'identification (01, 02) sont prévus, et en ce que l'ordinateur de test (15), après initiation par le courant de terre, envoie sur tous les câbles (5 à 7) l'adresse complétée du signal d'identification respectif.

6. Dispositif selon la revendication 5, caractérisé en ce que les appareils de test portatifs (21, 21′) comprennent un deuxième émetteur de signaux qui, par action sur une touche, envoie par les conducteurs de câble (7) à contrôler un signal de commande à l'ordinateur de test (15), après quoi l'ordinateur de test (15) met à la tension de travail la sortie correspondante (10) de l'armoire électrique (1).

7. Dispositif selon l'une des revendications 4 à 6, caractérisé en ce que la commande de l'armoire électrique présente un branchement de communication sur lequel se branche l'ordinateur de test (15), et en ce que l'ordinateur de test (15) est conçu de telle sorte que le signal d'identification (01, 02) émis par l'appareil de test portatif (21, 21′), à réception par l'ordinateur de test (15), commande la lecture et le stockage d'un compte-rendu de mesure de la commande de l'armoire électrique.
